## Europäisches Patentamt

## European Patent Office

## Office européen des brevets

(19)

(11) Veröffentlichungsnummer: **0 037 965**
**B1**

(12) **EUROPÄISCHE PATENTSCHRIFT**

(45) Veröffentlichungstag der Patentschrift:
**15.07.87**

(51) Int. Cl.⁴: **G 01 R 31/28**

(21) Anmeldenummer: **81102465.2**

(22) Anmeldetag: **01.04.81**

(54) **Einrichtung zum Prüfen einer digitalen Schaltung mittels in diese Schaltung eingebauter Prüfschaltungen.**

(30) Priorität: **11.04.80 US 139207**

(43) Veröffentlichungstag der Anmeldung:
**21.10.81 Patentblatt 81/42**

(45) Bekanntmachung des Hinweises auf die Patenterteilung:
**15.07.87 Patentblatt 87/29**

(84) Benannte Vertragsstaaten:
**BE DE FR GB IT NL**

(56) Entgegenhaltungen:
**DE - A - 2 413 805**
**DE - A - 2 508 716**
**US - A - 3 716 783**
**US - A - 3 761 695**
**US - A - 3 783 254**
**US - A - 3 784 907**

**Proceedings, 1979, IEEE Test Conference, Cherry Hill, New Jersey, Session 2, S. 37-41**
**Proceedings, 1977, Semiconductor Test Symposium, October 25-27, 1977, Cherry Hill, S. 19-27**

(73) Patentinhaber: **Siemens Aktiengesellschaft Berlin und München, Wittelsbacherplatz 2, D-8000 München 2 (DE)**

(72) Erfinder: **Fasang, Patrick Pad, 746 Fremont Lane, Mount Laurel New Jersey 08054 (US)**

ACTORUM AG

**Beschreibung**

Die vorliegende Erfindung betrifft eine neuartige und verbesserte Einrichtung zum Prüfen digitaler elektronischer Schaltungen, insbesondere eine Einrichtung zum automatischen Prüfen integrierter Schaltungen, gedruckter Schaltungskarten, die eine oder mehrere integrierte Schaltungen tragen, und darüber hinaus grösserer und komplexerer Systeme.

Das Prüfen elektronischer Schaltungsanordnungen nimmt mehr und mehr mit deren Komplexität an Bedeutung zu. Dies trifft nicht nur auf integrierte Schaltungen, sondern auch auf Baugruppen zu, die üblicherweise verschiedene integrierte Schaltkreise in Zusammenschaltung aufweisen, und sogar auch auf grössere Systeme, die solche Baugruppen und eine Vielzahl anderer Komponenten miteinander kombinieren.

Ein Prüfen ist nicht nur während des Fertigungsvorganges, sondern auch, nachdem solche Schaltungen oder Anlagen installiert worden sind, notwendig. Der Prüfvorgang für eine digitale Schaltung sollte so einfach und leicht wie möglich gestaltet werden, so dass er sogar durch den Anwender ausgeführt werden kann. Innerhalb eines solchen Prüfvorgangs ist es wichtig, zu bestimmen, ob eine betreffende digitale Schaltung die geforderten Lastenheftbedingungen erfüllt.

In den letzten Jahren wurden bereits zahlreiche Prüfeinrichtungen für integrierte Schaltungen entwickelt. Dabei setzte sich die grundsätzliche Auffassung durch, dass die integrierten Schaltungen unter Berücksichtigung von Prüfhilfen, die eine Selbstprüfung der elektronischen Einrichtung unterstützen können, ausgestattet werden sollten.

Prüfverfahren, die nach diesen Gesichtspunkten abgewickelt werden, sind allgemein unter der englischsprachigen Bezeichnung «Built-In Test» bekannt.

Aus «Proceedings, 1979 IEEE Test Conference», Cherry Hill, New Jersey, Session 2, Seiten 37 bis 41, aus der die im Oberbegriff des Patentanspruchs 1 genannten Merkmale bekannt sind, ist die Verwendung der sog. «Built-In Logic Block Observation Techniques» bekannt.

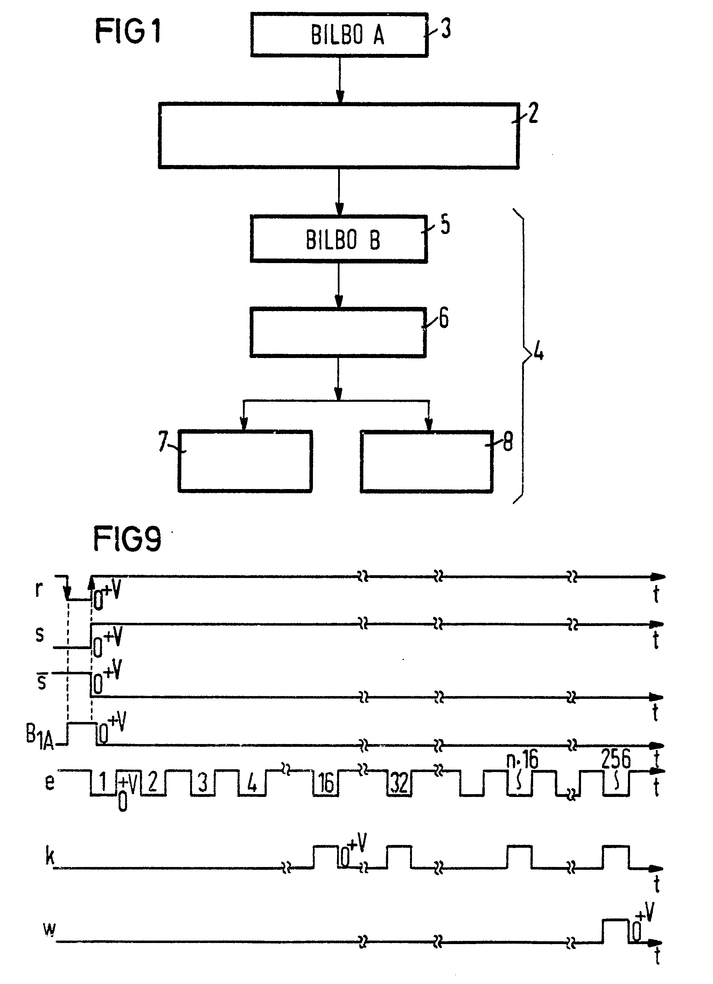

Prüfeinrichtungen entsprechend diesen Techniken sind vorrangig zum Prüfen integrierter Schaltungen vorgesehen. Eine Version (vgl. «Proceedings», supra, Fig. 1) einer solchen bekannten Einrichtung sieht vor, dass digitale Schaltungen durch Anregen der Eingänge der betreffenden Schaltungen während der Prüfung mit einer geeigneten Folge von Eingangswörtern, die als Prüfmuster bezeichnet ist, geprüft werden. Die zu prüfende Schaltung reagiert auf diesen Anreiz durch ein Ausgeben einer Folge von Ausgangswörtern, die als Testdaten bezeichnet werden. Es werden zwei Schritte zum Aufspüren eines Hardware-Fehlers in der zu prüfenden Schaltung unternommen:

1. An den Ausgängen der zu prüfenden Schaltung wird das Vorhandensein eines Fehlers geprüft. Dies geschieht mittels eines Vergleichsverfahrens. Wenn ein Fehler auftritt, unterscheidet sich die Folge von Testdaten, die von der zu prüfenden Schaltung abgegeben wird, von einer vorbestimmten normierten Folge, die eine fehlerfreie Schaltung abgegeben hätte. Ein bevorzugtes Verfahren zum Vergleichen der Testdaten mit den Normaldaten basiert auf einer zyklischen Codierung und einer Technik, die als «signature analysis» bekannt ist.

2. Die Tatsache, dass die erkannte Testdaten-Folge nicht mit der normierten Folge übereinstimmt, wird registriert, und es wird eine Fehlermeldung durch eine Prüfdaten-Auswerteeinrichtung gebildet.

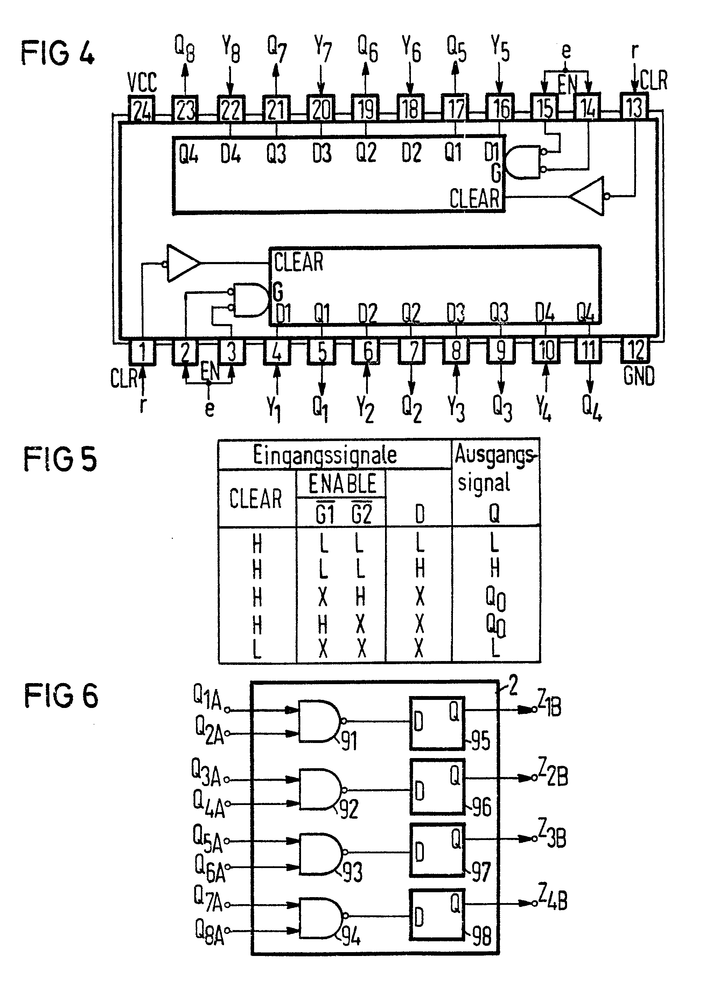

In «Proceedings, 1979 IEEE Test Conference», supra, vgl. Fig. 6, ist ausserdem ein multi-funktionales Subsystem gezeigt, dass als «Built-In Logic Observer» oder kurz als «BILBO» bezeichnet ist.

Eine solche Einrichtung «BILBO» kann für Datenübertragungszwecke und für Zwecke einer Fehlererkennung in komplexen digitalen Schaltungen verwendet werden. Die Einrichtung «BILBO» ist aus einer Reihe von Flipflop-Speichern und einigen zusätzlichen Gatterschaltungen für Verschiebe- und Rückkopplungsvorgänge zusammengesetzt. Im einzelnen sind im Regelfall acht Flipflops vorgesehen, deren Eingänge jeweils mit einer Gatter-Kombination verbunden sind. Jede Gatter-Kombination enthält ein NOR-Glied, ein Exklusiv-ODER-Glied und ein UND-Glied. Die Rückkopplung wird durch drei Exklusiv-ODER-Glieder vorgenommen. Ein erstes Steuereingangssignal wird dem ersten Eingang jedes der UND-Glieder, ein zweites Steuereingangssignal jedem ersten Eingang jedes der NOR-Glieder zugeführt. Die Ausgänge jedes der NOR-Glieder und der UND-Glieder sind mit den Eingängen eines Exklusiv-ODER-Gliedes verbunden. Den zweiten Eingängen der UND-Glieder werden Eingangsdaten zugeführt. Aus den Flipflops werden Ausgangssignale und die dazugehörenden komplementären Ausgangssignale gewonnen.

Die Einrichtung «BILBO» arbeitet in vier verschiedenen Betriebsarten. Bei der ersten Betriebsart arbeitet die Einrichtung als sperrende Schaltung. Bei der zweiten Betriebsart arbeitet sie als lineares Schieberegister. Dabei werden Daten seriell in das Schieberegister eingelesen, während die Schieberegisterinhalte gleichzeitig an den Ausgängen ausgelesen werden können. Bei der dritten Betriebsart ist die Einrichtung «BILBO» zu einem Vielfach-Eingangs-Kennungsregister umfunktioniert. Bei dieser dritten Betriebsart kann die Einrichtung «BILBO» zum Durchführen einer parallelen Kennungs-Analyse benutzt werden. Bei der vierten Betriebsart werden die Flipflops des Registers rückgesetzt.

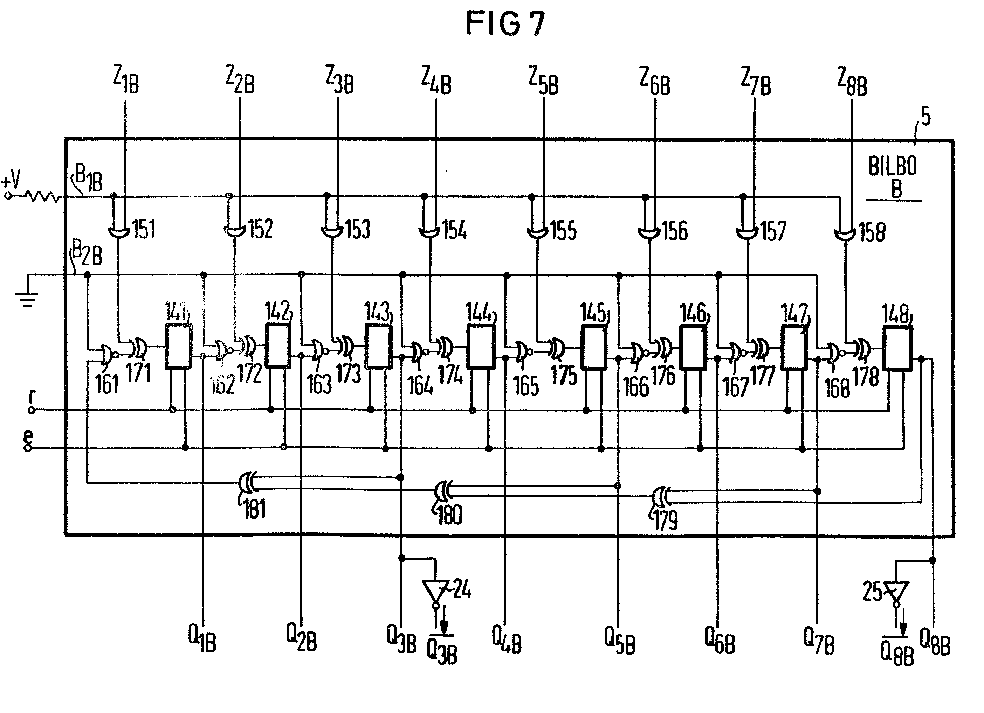

Zum Prüfen einer Schaltung können zwei Einrichtungen «BILBO» in einer modularen Busorientierten Anordnung (vgl. «Proceedings, 1979 IEEE Test Conference», supra, Fig. 7) verwendet werden. An der genannten Stelle sind jedoch Einzelheiten der Verbindungen zwischen diesen Einrichtungen «BILBO» einerseits und der zu prüfenden Schaltung andererseits nicht angegeben.

In «Proceedings, 1977 Semiconductor Test Symposium» October 25–27, 1977, Cherry Hill, Seiten 19 bis 27, sind zwei Konzepte zum Entwerfen digitaler Schaltungen in Verbindung mit deren Prüfung vorgeschlagen worden. Das erste Konzept besteht aus einem Entwurf derart, dass ein einwandfreier Betrieb weder von der Alterung, noch der gesamten oder der minimalen Verzögerung der individuellen Schaltung abhängt. Die einzige Abhängigkeit besteht darin, dass die totalen Verzögerungen über eine Anzahl von Stufen hinweg kleiner als einige bekannte Werte sind. Diese Technik ist als «Level Sensitive Design» bekannt. Das zweite Konzept besteht aus einem Entwurf aller internen Speicherelemente (nicht als Speichermatritzen angeordnet) derart, dass sie als Schieberegister arbeiten können. Netzwerke, die beide dieser Merkmale haben, sind als «Level Sensitive Scan Designs» oder «LSSD» bekannt. Wenn ein Entwurf diese Struktur aufweist, können diesem Netzwerk beliebige Prüfmuster ohne Rücksicht auf die sequentiellen Eigenschaften dieses Netzwerks zugeführt werden. Die «LSSD»-Tecknik stellt eine Verbesserung der sog. «scan path techniques» dar. Einzelheiten dieser «scan path techniques» sind in US-A-3 783 254, US-A-3 761 695 und US-A-3 784 907 offenbart.

Aus der Druckschrift US-A-3 716 783 ist bereits ein Prüfsystem zum Prüfen der Funktionseigenschaften einer digitalen Schaltungsanordnung bekannt, das u.a. eine Steuerschaltung, eine Taktsteuerschaltung, die durch einen Taktsteuerimpuls aus der Steuerschaltung gesteuert wird, einen Ausgabe-Codierer und einen Komparator enthält. Die zu prüfende digitale Schaltungsanordnung wird gemäss diesem bekannten Prüfsystem mit Prüfeingangsdatenwörtern versorgt, und die sich jeweils ergebenden Ausgangsdaten werden in vorbestimmter Weise miteinander mittels des Komparators verglichen, aus welchem Vergleich sich entweder ein «Gut»- oder ein «Schlecht»-Signal ergibt.

Der vorliegenden Erfindung liegt die Aufgabe zugrunde, eine Einrichtung zum Prüfen einer digitalen Schaltung zu schaffen, die nicht nur auf integrierte Schaltkreise anwendbar ist, sondern ebenfalls sowohl auf gedruckte Schaltungen als auch auf Systeme, die digitale Schaltungen enthalten, welche ihrerseits eine Vielzahl von integrierten Schaltkreisen aufweisen. Ferner soll die Einrichtung in der Lage sein, festzustellen, ob eine gegebene zu prüfende digitale Schaltung die geforderten Lastenheftbedingungen erfüllt. Ausserdem soll die Einrichtung erlauben, eine digitale Schaltung ohne zusätzliche externe Prüfeinrichtungen zu prüfen. Desweiteren soll die Einrichtung von sich aus ein Prüfverfahren für eine digitale Schaltung abwickeln können. Ferner soll die Einrichtung einen einfachen Aufbau aufweisen. Die erfindungsgemässe Einrichtung soll aufgabengemäss eine Vielzahl von gleichartigen Grundschaltungs-Elementen haben, die eine Vielfachfunktionseinheit bilden, wobei die Funktion davon abhängen soll, wie diese Elemente gesteuert werden. Desweiteren besteht die Aufgabe für die Erfindung darin, eine Einrichtung zu schaffen, die auf dem Markt erhältliche integrierte Schaltkreise als Grundelemente zum Aufbau verwendet. Ferner soll aufgabengemäss eine Einrichtung geschaffen werden, die den Zustand «Fehlerhaft» oder den Zustand «Fehlerfrei» der zu prüfenden digitalen Schaltung anzeigt.

Die der Erfindung zugrundeliegende Aufgabe wird durch eine Einrichtung gemäss dem Oberbegriff des Patentanspruchs 1 gelöst, die durch die in dessen kennzeichnendem Teil angegebenen Merkmale charakterisiert ist.

Im Betrieb der Einrichtung gemäss der vorliegenden Erfindung sind zwei Einrichtungen BILBO mit der zu prüfenden Schaltung verbunden. Die zu prüfende Schaltung wird dabei in den Prüfzustand versetzt. Die erste eingebaute Prüfschaltung BILBO erzeugt ein Pseudo-Zufalls-Prüfmuster, um die zu prüfende Schaltung anzureizen. Die zweite eingebaute Prüfschaltung BILBO empfängt die Ergebnisdaten oder das Ergebnismuster von der zu prüfenden Schaltung über einen Parallel-Datenbus und speichert diese Daten. Die Ergebnisdaten werden anschliessend durch den Decoder decodiert, um die Fehlerfreiheit der Arbeitsweise der zu prüfenden Schaltung zu beurteilen. Der Zustandsanzeiger gibt ein Zustandssignal «Fehlerfrei» oder «Fehlerhaft» entsprechend dem Zustand der zu prüfenden Schaltung ab.

Vorteilhafte Weiterbildungen der Erfindung sind durch die in den abhängigen Ansprüchen 2 bis 6 angegebenen Merkmale gekennzeichnet.

Es sei vermerkt, dass die bekannten Einrichtungen BILBO (vgl. «Proceedings, 1979 IEEE Test Conference», Cherry Hill, New Jersey, supra) als erste eingebaute Prüfschaltung BILBO und als zweite eingebaute Prüfschaltung BILBO mit nur geringfügigen Änderungen verwendet werden können.

Die Einrichtung gemäss der vorliegenden Erfindung vereinfacht die Prüfvorgänge für komplexe elektronische Schaltungen, die integrierte Schaltkreise enthalten, Bus-orientierte gedruckte Schaltungen und grössere Systeme. Die Einrichtung kann ebenso in Verbindung mit Schaltsystemen verwendet werden, die nicht Bus-orientiert sind.

Die beiden eingebauten Prüfschaltungen BILBO bilden gemeinsam mit dem Decoder und dem Zustandsanzeiger eine selbstarbeitende Prüfeinrichtung derart, dass eine Schaltung auf einfache Art und Weise auch beim Anwender mit minimalen Anforderungen an zusätzliche Hardware oder sonstige Einrichtungen durchgeprüft werden kann.

Wie zuvor erwähnt, ist die zweite eingebaute Prüfschaltung BILBO als Parallel-Eingangswort-Analysator ausgelegt. Durch diesen Umstand wird die Prüfzeit verringert.

Die zuvor genannte Aufgabenstellung und weitere Aufgaben, Merkmale und Vorteile der vorliegenden Erfindung werden im folgenden durch die ins einzelne gehende Beschreibung bevorzugter Ausführungsbeispiele der Erfindung, wie sie aus der Zeichnung hervorgehen, verdeutlicht.

Im folgenden wird die Erfindung anhand mehrerer, Ausführungsbeispiele für die Erfindung betreffender Figuren im einzelnen erläutert.

Fig. 1 zeigt ein Blockschaltbild einer Einrichtung zum Prüfen gemäss der vorliegenden Erfindung.

Fig. 2 zeigt ein mehr ins einzelne gehendes Schaltbild eines Ausführungsbeispiels für die vorliegende Erfindung.

Fig. 3 zeigt ein Schaltbild eines Ausführungsbeispiels für eine fest eingebaute Prüfschaltung BILBO A, die als Pseudo-Zufalls-Prüfmuster-Generator ausgelegt ist.

Fig. 4 zeigt ein Schaltbild einer 2-fach-4-Bit-Sperrschaltung, die als eine Flipflop-Anordnung in der ersten und/oder zweiten eingebauten Prüfschaltung BILBO A bzw. BILBO B benutzt werden kann.

Fig. 5 zeigt eine Funktionstabelle der 2-fach-Sperrschaltung gemäss Fig. 4.

Fig. 6 zeigt ein Schaltbild einer typischen zu prüfenden Schaltung, die vier NAND-Glieder und vier Flipflops aufweist.

Fig. 7 zeigt ein Schaltbild eines Ausführungsbeispiels für die zweite eingebaute Prüfschaltung BILBO B.

Fig. 8 zeigt ein Schaltbild eines Ausführungsbeispiels für eine Steuerschaltung in Verbindung mit einer Taktsteuerungsschaltung.

Fig. 9 zeigt ein Taktimpuls-Diagramm, das sich auf die Schaltungsanordnungen gemäss Fig. 2 bis Fig. 8 bezieht.

Wie bereits erläutert, zeigt Fig. 1 ein Blockschaltbild eines Ausführungsbeispiels für die Einrichtung gemäss der vorliegenden Erfindung. Darin ist eine zu prüfende digitale Schaltung mit 2 bezeichnet. Die digitale Schaltung 2 kann beispielsweise eine integrierte Schaltung, eine gedruckte Schaltung mit einer Vielzahl von Komponenten, wie Transistoren, Widerstände, Kondensatoren, oder ein System, bestehend aus gedruckten Schaltungsbaugruppen, sein. Die zu prüfende Schaltung 2 ist derart aufgebaut, dass sie die Bedingungen der bereits erwähnten «LSSD»-Technik, wie in der Literatur beschrieben, vgl. beispielsweise «Proceedings, 1977 Semiconductor Test Symposium», October 25–27, Cherry Hill, Seiten 19–27, erfüllt. Aus Gründen der Einfachheit wird angenommen, dass die zu prüfende Schaltung 2 keinen irgendwie gearteten Mikroprozessor enthält.

Mit dem Eingang der zu prüfenden Schaltung 2 ist eine erste eingebaute Prüfschaltung 3 verbunden die auch mit «BILBO A» bezeichnet ist. Diese erste eingebaute Prüfschaltung 3 (BILBO A) stellt einen speziellen Prüfmuster-Generator, nämlich einen Pseudo-Zufalls-Prüfmuster-Generator dar, wie später eingehend erläutert wird.

Mit dem Ausgang der Schaltung 2 ist eine Prüfdaten-Auswerteeinrichtung 4 verbunden. Diese Prüfdaten-Auswerteeinrichtung 4 besteht aus einer zweiten eingebauten Prüfschaltung 5 (BILBO B), einem Decoder 6 und zwei Zustandsanzeigern, nämlich einem ersten Zustandsanzeiger 7 und einem zweiten Zustandsanzeiger 8, zum Anzeigen der Zustände «Fehlerfrei» oder «Fehlerhaft» der Schaltung 2. Die zweite eingebaute Prüfschaltung 5, die mit «BILBO B» bezeichnet ist, ist als Parallel-Eingangswort-Analysator ausgelegt, wie weiter unten erläutert wird. Die zweite eingebaute Prüfschaltung 5 (BILBO B) ist mit dem Ausgang der Schaltung 2 verbunden. Der Eingang des Decoders 6 ist an den Ausgang der zweiten eingebauten Prüfschaltung 5 (BILBO B) angeschlossen. Der Decoder 6 versorgt mit seinen Ausgangssignalen die beiden Zustandsanzeiger 7 und 8.

Während eines Prüfvorganges wird die zu prüfende digitale Schaltung 2 in ihren Prüfzustand versetzt. Die erste eingebaute Prüfschaltung 3 (BILBO A) erzeugt Prüfmuster, die an die Schaltung 2 abgegeben werden. Infolge dieser Prüfmuster gibt die Schaltung 2 Prüfdaten oder Ergebnisdaten ab. Diese Ergebnisdaten werden der zweiten eingebauten Prüfschaltung 5 (BILBO B) über einen Parallel-Datenbus zugeführt. Das Ausgangssignal der zweiten eingebauten Prüfschaltung 5 (BILBO B) wird dem Decoder 6 zugeführt, der das Ausgangssignal decodiert und ein korrespondierendes Signal an den Zustandsanzeiger 7 oder 8 abgibt. Abhängig von dem Zustand der Schaltung 2 wird entweder der erste Zustandsanzeiger 7 oder der zweite Zustandsanzeiger 8 aktiviert.

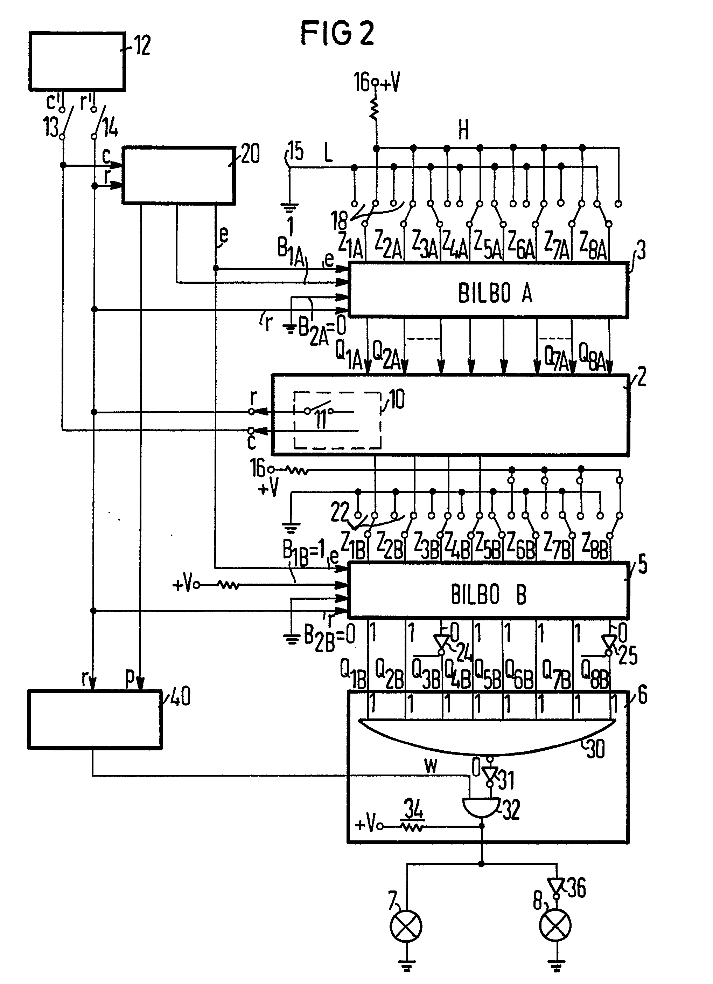

Wie Fig. 2 zeigt, enthält die zu prüfende Schaltung 2 eine Haupttakt- und Rücksetzschaltung 10. Diese Haupttakt- und Rücksetzschaltung 10 erzeugt ein Haupttaktsignal c und ein Hauptrücksetzsignal r. Wie schematisch angedeutet ist, kann das Hauptrücksetzsignal r dann gewonnen werden, wenn ein erster Schalter 11 geschlossen ist. Dieser erste Schalter 11 kann manuell betätigt werden. Er kann beispielsweise der Stromversorgungsschalter der zu prüfenden Schaltung 2 oder ein besonderer Rücksetzschalter sein.

In einem Fall, bei dem die zu prüfende Schaltung 2 keine eigene Haupttakt- und Rücksetzschaltung 10 aufweist, ist eine besondere Haupttakt- und Rücksetzschaltung vorgesehen. Diese besondere Haupttakt- und Rücksetzschaltung 12 kann auf der gleichen Platte wie die Schaltung 2, die erste eingebaute Prüfschaltung 3, die zweite eingebaute Prüfschaltung 5, der Decoder 6 und falls vorgesehen, der erste Zustandsanzeiger 7 und der zweite Zustandsanzeiger 8 angeordnet sein. Die besondere Haupttakt- und Rücksetzschaltung 12 liefert ein Haupttaktisignal $c'$, das dem Haupttaktsignal c entspricht, und ein Hauptrücksetzsignal $r'$, das dem Hauptrücksetzsignal r entspricht. Die Signale $c'$ und $r'$ können der übrigen Einrichtung über einen ersten Prüfschalter 13 bzw. einen zweiten Prüfschalter 14 zugeführt werden. Der zweite Prüfschalter 14 kann ein manuell zu betätigender Rücksetzschalter sein.

Bei dem Ausführungsbeispiel gemäss Fig. 2 ist angenommen, dass die erste eingebaute Prüfschaltung 3 (BILBO A) ein 8-Bit-BILBO ist. Demgemäss hat die erste eingebaute Prüfschaltung 3 (BILBO A) acht Eingangsklemmen $Z_{1A}$, $Z_{2A}$...$Z_{8A}$, die mit Eingangssignalen versorgt werden. Es ist jedoch darauf hinzuweisen, dass eine erste eingebaute Prüfschaltung 3 (BILBO A) mit einer Anzahl von Eingangsklemmen benutzt werden kann, die von der Anzahl 8 abweicht, nämlich der Anzahl von Bits, die ausgewählt wird, um die Schaltung 2 auf geeignete Art und Weise zu prüfen.

Wie in Fig. 2 gezeigt, sind die Eingänge $Z_{3A}$, $Z_{5A}$ und $Z_{8A}$ der ersten eingebauten Prüfschaltung 3 (BILBO A) auf Erdpotential 15 gelegt, während die Eingänge $Z_{1A}$, $Z_{2A}$, $Z_{4A}$, $Z_{6A}$ und $Z_{7A}$ über einen Widerstand auf ein Potential $+V$ gelegt sind. Dies bedeutet, dass die acht Eingänge in eine erste bzw. zweite Gruppe eingeteilt sind. Die Verbindung entweder mit dem Erdpotential oder mit dem Potential $+V$ ist über Schalter hergestellt, die mit 18 bezeichnet sind. Eine Verbindung mit dem Erdpotential 15 entspricht einem Eingangssignal mit dem logischen Wert «0». Eine Verbindung mit dem Potential $+V$ entspricht einem Eingangssignal mit dem logischen Wert «1». Durch Umlegen der Schalter 18 wird die erste Gruppe von Eingängen mit Eingangssignalen entsprechend dem logischen Wert «1» und die zweite Gruppe von Eingängen mit Eingangssignalen entsprechend dem logischen Wert «0» beaufschlagt. Die Auswahl der beiden Gruppen hängt von der Struktur der zu prüfenden Schaltung 2 ab.

Das Umlegen der Schalter 18 kann entweder manuell oder durch ein Rechnerprogramm gesteuert durchgeführt werden. In einem bevorzugten Ausführungsbeispiel sind die Schalter 18 jedoch insgesamt fortgelassen, und die Verbindungen sind fest verdrahtet.

Zusätzlich zu den Eingangssignalen an den Eingängen $Z_{1A}$, $Z_{2A}$...$Z_{8A}$ empfängt die erste eingebaute Prüfschaltung 3 (BILBO A) vier weitere Signale, nämlich $B_{1A}$, $B_{2A}$, e und r. Die Signale $B_{1A}$ und $B_{2A}$ sind Steuersignale. Das erste Steuersignal $B_{1A}$ wird von einer Steuerschaltung 20 abgegeben. Es entspricht entweder dem logischen Wert «0» oder dem logischen Wert «1». Das zweite Steuersignal $B_{2A}$ entspricht dem logischen Wert «0». Der korrespondierende Steuereingang ist auf Erdpotential gelegt. Das Signal e, das ein Freigabesignal ist, wird ebenfalls aus der Steuerschaltung 20 gewonnen. Es wird auch der zweiten eingebauten Prüfschaltung 5 (BILBO B) zugeführt. Das vierte zusätzliche Signal, das die erste eingebaute Prüfschaltung 3 (BILBO A) empfängt, ist das Hauptrücksetzsignal r.

Die erste eingebaute Prüfschaltung 3 (BILBO A) hat beispielsweise acht Ausgänge $Q_{1A}$, $Q_{2A}$...$Q_{7A}$, $Q_{8A}$, die mit der zu prüfenden Schaltung 2 verbunden sind und über die entsprechenden Ausgangssignale ausgegeben werden.

Die zweite eingebaute Prüfschaltung 5 (BILBO B) hat in dem Ausführungsbeispiel gemäss Fig. 2 ebenfalls acht Eingänge $Z_{1B}$, $Z_{2B}$...$Z_{7B}$, $Z_{8B}$. Dementsprechend empfängt die zweite eingebaute Prüfschaltung 5 (BILBO B) Eingangssignale, die 8 Bit breit sind. In anderen Ausführungsbeispielen könnte die zweite eingebaute Prüfschaltung 5 (BILBO B) eine unterschiedliche Anzahl Bits, beispielsweise vier oder 16, aufnehmen. Die acht Eingänge sind in drei Gruppen eingeteilt. Die erste Gruppe, die die ersten vier Eingänge $Z_{1B}$...$Z_{4B}$ enthält, ist über Schalter mit vier Ausgängen der zu prüfenden Schaltung 2 verbunden. Eine zweite Gruppe von Eingängen ist über Schalter auf Erdpotential gelegt, was Eingangssignale mit dem logischen Wert «0» erzeugt. Die zweite Gruppe enthält die Eingänge $Z_{5B}$, $Z_{6B}$ und $Z_{7B}$. Der Eingang $Z_{8B}$, der die dritte Gruppe repräsentiert, ist über einen weiteren Schalter und einen Widerstand mit einer Spannungsklemme 16, die ein Potential $+V$ hat, verbunden. Daraus ergibt sich ein Eingangssignal mit dem logischen Wert «1». Diese Schalter, durch die eine Auswahl für die Eingangssignale getroffen werden kann, sind mit 22 bezeichnet.

Die Auswahl der drei Gruppen und die Verbindung der Eingänge entweder mit der zu prüfenden Schaltung 2, mit Erdpotential oder der Spannungsklemme 16 hängt von der Struktur der zu prüfenden Schaltung 2 ab. Es sei vermerkt, dass die Schalter 22 entweder manuell oder durch Steuerung mittels eines Rechnerprogramms betätigt werden können. In einem bevorzugten Ausführungsbeispiel sind die Schalter 22 jedoch insgesamt fortgelassen, und die Verbindungen der Ausgänge der zu prüfenden Schaltung 2 mit Erdpotential und mit der Spannungsklemme 16 sind fest verdrahtet.

Zusätzlich zu den Eingangssignalen an den Eingängen $Z_{1B}$, $Z_{2B}$...$Z_{8B}$ empfängt die zweite eingebaute Prüfschaltung 5 (BILBO B) vier Steuersignale $B_{1B}$, $B_{2B}$, e und r. Um die zweite eingebaute Prüfschaltung 5 (BILBO) als Parallel-Eingangswort-Analysator zu betreiben, werden die Eingangssignale mit $B_{1B}=1$ und $B_{2B}=0$ gewählt. Der erste Steuereingang ist mit einer Spannungsklemme, die das Potential $+V$ hat, verbunden. Der zweite Steuereingang ist auf Erdpotential gelegt. Die anderen beiden Signale sind das Freigabesignal aus der Steuerschaltung 20 und das Hauptrücksetzsignal r.

Die zweite eingebaute Prüfschaltung 5 (BILBO B) hat ebenfalls acht Ausgänge. Es sei beispielsweise – wie in der Figur gezeigt – angenommen, dass das 8-Bit-Ausgangssignal die Kombination 11011110 der logischen Werte «0» und «1» aufweist. Es sei ferner angenommen, dass die Kombination 11011110 der logischen Werte einer vorbestimmten Kombination entspricht, die gelten soll, wenn die zu prüfende Schaltung 2 fehlerfrei ist.

Um eine Eingangskombination 11111111, die also nur aus Bits mit dem logischen Wert «1» besteht, an dem Eingang des folgenden Decoders 6 zu erhalten, sind zwei Inverter 24 und 25 zwischen den dritten Ausgang der zweiten eingebauten Prüfschaltung 5 (BILBO B) und den dritten Eingang des Decoders 6 bzw. zwischen den achten Ausgang der zweiten eingebauten Prüfschaltung 5 (BILBO B) und den achten Eingang des Decoders 6 eingefügt. Die dem Decoder 6 zugeführten Eingangssignale sind mit $Q_{1B}$, $Q_{2B}$, $\overline{Q_{3B}}$, $Q_{4B}$, $Q_{5B}$, $Q_{6B}$, $Q_{7B}$ und $\overline{Q_{8B}}$ bezeichnet. Die Inverter 24 und 25 können ein Teil des Decoders 6 sein.

Es sei ebenfalls angemerkt, dass die Ausgangssignale an den Ausgängen der zweiten eingebauten Prüfschaltung 5 (BILBO B) eine Kombination von logischen Wert darstellen, die unterschiedlich von der vorherbestimmten Kombination 11011110 ist, wenn die zu prüfende Schaltung 2 fehlerhaft ist. In einem solchen Fall haben die Eingangssignale des Decoders 6 nicht alle den gleichen logischen Wert. Zumindest eines von ihnen wird den logischen Wert «0» aufweisen.

Der Decoder 6 enthält ein als NAND-Glied aufgeführtes Summierglied 30 mit acht Eingängen. Die Eingangssignale des Decoders 6 werden diesen acht Eingängen des Summiergliedes 30 zugeführt. Der Ausgang des Summiergliedes 30 ist über einen Inverter 31 mit dem ersten Eingang eines Sperrgliedes 32 verbunden. Dieses Sperrglied 32 ist als UND-Glied ausgeführt. Sein zweiter Eingang empfängt ein Prüfendesignal, das mit w bezeichnet ist. Der Ausgang des Sperrgliedes 32 stellt den Ausgang des Decoders 6 dar. An diesen Ausgang ist ein mit einer Spannungsklemme mit dem Potential +V verbundener Speisewiderstand 34 angeschlossen. Der Speisewiderstand 34 dient dazu, die Zustandsanzeiger 7 und 8 mit Strom zu versorgen, da das Ausgangssignal des Sperrgliedes 32 zu schwach sein kann, um lichtemittierende Dioden LED zu versorgen, die als Zustandsanzeiger 7 und/oder 8 verwendet werden können.

Aus Fig. 2 geht hervor, dass das Summierglied 30 ein Ausgangssignal mit dem logischen Wert «0» abgibt, wenn alle acht Eingangssignale den logischen Wert «1» aufweisen, und ein Ausgangssignal mit dem logischen Wert «1» abgibt, wenn zumindest eines oder acht Eingangssignale den logischen Wert «0» aufweist. Demnach weist das Ausgangssignal des Inverters 31 den logischen Wert «1» auf, wenn die prüfende Schaltung fehlerfrei ist.

Ein Ausgangssignal des Summiergliedes 30 mit dem logischen Wert «0» hat ein Ausgangssignal mit dem logischen Wert «1» (= Ausgangssignal für den Zustand «Fehlerfrei») des Decoders 6 nur dann zur Folge, wenn das Prüfendesignal w den logischen Wert «1» annimmt. Wie später aus Fig. 9 zu entnehmen sein wird, tritt dies am Ende einer Prüfperiode ein, wenn der letzte Impuls einer Folge von Impulsen erzeugt wird. Während der Erzeugungszeit der vorhergehenden Impulse dieser Impulsfolge weist das Prüfendesignal w den logischen Wert «0» auf. Deshalb hat auch das Ausgangssignal des Decoders 6 zu diesem Zeitpunkt den logischen Wert «0».

Im Prinzip stellen das Summierglied 30, der Inverter 31 und das Sperrglied 32 ein 9-Bit-UND-Glied dar. Ein solches 9-Bit-UND-Glied kann selbstverständlich auf andere Weise als in der Figur gezeigt realisiert werden.

Das Ausgangssignal des Decoders 6 wird dem ersten Zustandsanzeiger 7 direkt und dem zweiten Zustandsanzeiger 8 über einen weiteren Inverter 36 zugeführt. Demzufolge wird der erste Zustandsanzeiger 7 in dem Zustand «Fehlerfrei» aktiv, während der zweite Zustandsanzeiger 8 dabei inaktiv bleibt. Der erste Zustandsanzeiger 7 bleibt in dem Zustand «Fehlerhaft» inaktiv, während in diesem Fall der zweite Zustandsanzeiger 8 aktiv wird.

Die Zustandsanzeiger 7 und 8 können als beliebige optische, akustische oder mechanische Anzeiger, beispielsweise lichtemittierende Dioden LED, ein Summer oder ein Schauzeichen ausgeführt sein.

Wie zuvor erläutert, empfängt die Steuerschaltung 20 als Eingangssignale das Haupttaktsignal c und das Hauptrücksetzsignal r (oder dementsprechend die Signale c′ und r′). Die Steuerschaltung 20 liefert das Freigabesignal e, das erste Steuersignal $B_{1A}$ für die erste eingebaute Prüfschaltung 3 (BILBO A) und Taktsteuerungsimpulse p. Diese Taktsteuerungsimpulse p werden einer Taktsteuerungsschaltung 40 zugeführt. Die Taktsteuerungsschaltung 40 empfängt ebenfalls das Hauptrücksetzsignal r. Sie gibt als Ausgangssignal das Prüfendesignal w ab.

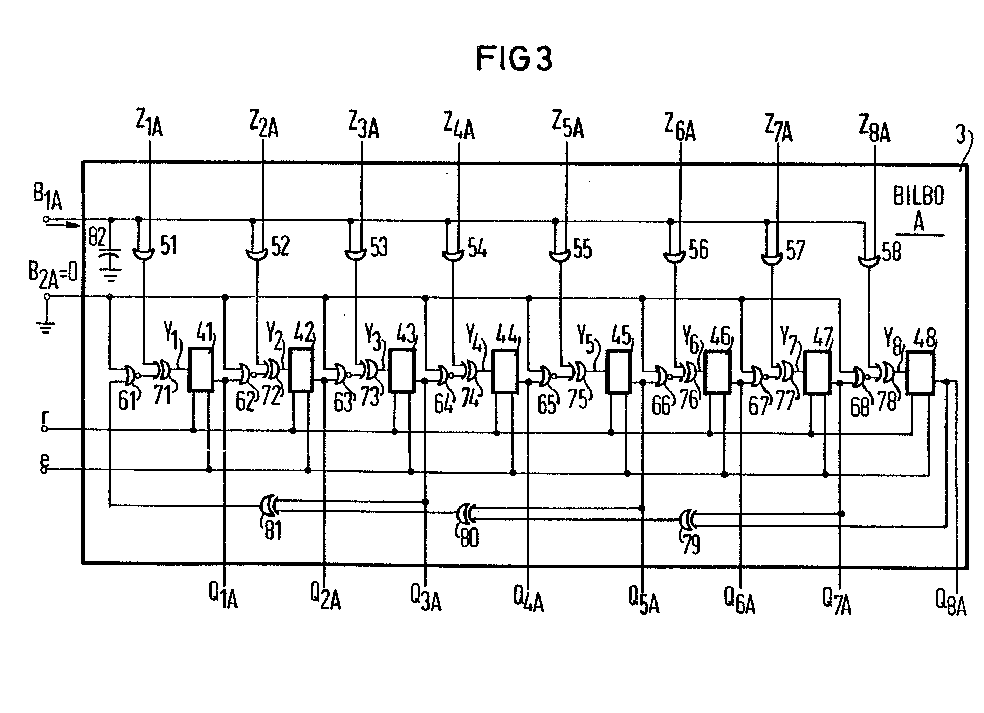

Fig. 3 zeigt, wie bereits erläutert, ein Ausführungsbeispiel für die erste eingebaute Prüfschaltung 3 (BILBO A). Dieses Ausführungsbeispiel ist im wesentlichen von gleicher Art wie die Einrichtung «BILBO», die in «Proceedings, 1979 IEEE Test Conference», supra gezeigt ist. Es sei jedoch angemerkt, dass bei der vorliegenden Erfindung kein sog. Multiplexer benötigt wird. Im einzelnen enthält die erste eingebaute Prüfschaltung 3 (BILBO A) acht Speicherelemente, nämlich Flipflops 41...48, acht UND-Glieder 51...58, acht NOR-Glieder 61...68, acht Exklusiv-ODER-Glieder 71...78 und drei zusätzliche ODER-Glieder 79, 80 u. 81 in einer Rückkopplungsschleife. Um die Impulse des ersten Steuersignals $B_{1A}$ zu verlängern, ist ein Kondensator 82 parallel zu dem ersten Steuereingang angeschlossen.

Ins einzelne gehend ist auszuführen, dass die erste eingebaute Prüfschaltung 3 (BILBO A) 8 Moduln oder Baugruppen enthält, die miteinander in Reihe geschaltet sind. Jede Baugruppe besteht aus einem Speicherelement und einer Gatter-Kombination, um dem Ausgangssignal eines Speicherelements zu ermöglichen, an den Eingang des nächsten Speicherelements zu gelangen. In dem gezeigten Ausführungsbeispiel bestehen die Gatter-Kombinationen aus einem UND-Glied, einem NOR-Glied und einem Exklusiv-ODER-Glied. Beispielsweise besteht das vierte Modul aus einem vierten Flipflop 44, einem vierten UND-Glied 54, einem vierten NOR-Glied 64 und einem vierten Exklusiv-ODER-Glied 74. Der erste Eingang des vierten NOR-Gliedes 64 ist mit dem Ausgang des dritten Flipflop 43 verbunden. Der zweite Eingang des vierten NOR-Gliedes 64 wird mit dem zweiten Steuersignal $B_{2A}=0$ versorgt. Das vierte Exklusiv-ODER-Glied 74 ist mit seinem ersten Eingang an den Ausgang des vierten NOR-Gliedes 64 und mit seinem zweiten Eingang an den Ausgang des vierten UND-Gliedes 54 angeschlossen. Der Ausgang des vierten Exklusiv-ODER-Gliedes 74 ist mit dem vierten Flipflop 44 verbunden. Das vierte UND-Glied 54 wird am Eingang mit dem ersten Steuersignal $B_{1A}$ und an der vierten Eingangssignal-Eingangsklemme $Z_{4A}$ mit dem vierten Eingangssignal versorgt. Der Ausgang des vierten Flipflop 44 gibt das Ausgangssignal $Q_{4A}$ ab, das dem vierten Ausgang der ersten eingebauten Prüfschaltung 3 (BILBO A) zugeführt wird. Das Signal $Q_{4A}$ wird ausserdem dem ersten Eingang des NOR-Gliedes 65 des nächsten Modul zugeführt. Die anderen Moduln haben die gleiche Struktur wie das vierte Modul.

In dem vorliegenden Ausführungsbeispiel für die erste eingebaute Prüfschaltung 3 (BILBO A) ist die Rückkopplungsschleife mit ihrem Ausgang an den ersten Eingang des ersten NOR-Gliedes 61 angeschlossen. Das zusätzliche Exklusiv-ODER-Glied 79 wird mit den Ausgangssignalen $Q_{7A}$ und $Q_{8A}$ des siebten bzw. achten Flipflop 47 bzw. 48 versorgt. Das zusätzliche Exklusiv-ODER-Glied 80 wird durch das Ausgangssignal $Q_{5A}$ des fünften Flipflop 45 und das Ausgangssignal des Exklusiv-ODER-Gliedes 79 versorgt. Das Exklusiv-ODER-Glied 81, das das letzte Glied in der Rückkopplungsschleife darstellt, wird durch das Ausgangssignal $Q_{3A}$ des dritten Flipflop 43 und das Ausgangssignal des Exklusiv-ODER-Gliedes 80 versorgt. Der Ausgang des Exklusiv-ODER-Gliedes 81 ist der Ausgang der Rückkopplungsschleife.

Die acht Flipflops 41...48 empfangen als Eingangssignale ebenfalls das Hauptrücksetzsignal r und das Freigabesignal e.

Infolge der Steuersignale $B_{1A}$ und $B_{2A}$ ($B_{2A}=0$) wird die erste eingebaute Prüfschaltung 3 (BILBO A) als lineares Schieberegister geschaltet. Die Funktion der ersten eingebauten Prüfschaltung 3 (BILBO A) besteht darin, ein Pseudo-Zufalls-Prüfmuster zu erzeugen. In dem vorliegenden Ausführungsbeispiel entspricht die maximale Periode des Prüfmusters 255 Impulsen des Haupttaktsignals c. Das Pseudo-Zufalls-Prüfmuster wird aus den acht Ausgängen der ersten eingebauten Prüfschaltung 3 (BILBO A) als Ausgangssignale $Q_{1A}$, $Q_{2A}$...$Q_{8A}$ gewonnen.

Es sei vermerkt, dass die UND-Glieder 51...58 vom Typ 7408, die NOR-Glieder 61...68 vom Typ 7402 und die Exklusiv-ODER-Glieder 71...78 vom Typ 7486 der Firma Texas Instruments Incorporated, Dallas, Texas sind.

Es sei zudem vermerkt, dass die acht Flipflops 41...48 aus einfachen Standard-Schaltkreisen, beispielsweise vom Typ 74116 (Dual 4-Bit Latches with Clear) der Firma Texas Instruments aufgebaut sind. Einzelheiten solcher Standard-Schaltkreise sind in Fig. 4 und der korrespondierenden Funktionstabelle gemäss Fig. 5 gezeigt.

In dem Standard-Schaltkreis gemäss Fig. 4 sind die Eingangssignale und die Ausgangssignale mit einem ersten Index, jedoch ohne einen zweiten Index angegeben. Der Grund dafür ist, dass der Standard-Schaltkreis gemäss Fig. 4 ebenso dazu benutzt werden kann, die Kette von Flipflops in der zweiten eingebauten Prüfschaltung 5 (BILBO B) zu realisieren. Aus diesem Grunde können Fig. 4 und Fig. 5 ebenfalls als Grundlage für den Ausbau der zweiten eingebauten Prüfschaltung 5 (BILBO B) verwendet werden.

Die Eingangssignale der acht Flipflops sind mit $Y_1$, $Y_2$...$Y_8$ bezeichnet. Die Ausgangssignale sind mit $Q_1$, $Q_2$...$Q_8$ bezeichnet. Das Lösch- oder Rücksetzsignal ist das Signal r. Das Freigabesignal ist das Signal e. Die Nummern in den einzelnen Blökken bezeichnen die Stiftnummern des betreffenden Typs. In der Funktionstabelle gemäss Fig. 5 bezeichnet H einen hohen Pegel, L einen niedrigen Pegel, X einen irrelevanten Signalzustand und $Q_0$ den Pegel des Signals Q, bevor die betreffenden Eingangsbedingungen erfüllt sind.

In Fig. 6 ist ein willkürlich ausgewähltes Beispiel für eine zu prüfende Schaltung 2 gezeigt. Diese spezielle Schaltung 2 enthält vier NAND-Glieder 91...94 und vier Flipflops 95...98. Es wird angenommen, dass das erste NAND-Glied 91 die beiden Eingangssignale $Q_{1A}$ und $Q_{2A}$ von der ersten eingebauten Prüfschaltung 3 (BILBO A) empfängt. Der Ausgang des ersten NAND-Gliedes 91 ist mit dem Eingang des ersten Flipflop 95 verbunden. Der Ausgang des ersten Flipflop 95 liefert das erste Ausgangssignal, das an den Eingang $Z_{1B}$ weitergeleitet wird. Eine entsprechende Konfiguration ist für die anderen Kombinationen von NAND-Gliedern und Flipflops ausgewählt.

Im normalen Betrieb können die Eingangssignale $Q_{1A}$...$Q_{8A}$ von der zu prüfenden Schaltung 2 abgetrennt und/oder an andere Komponenten (nicht in Fig. 6 gezeigt) angeschaltet werden. Das bedeutet, dass im normalen Betrieb der Anreiz für die zu prüfende Schaltung 2 von einem beliebigen Ort kommen kann. Die zu prüfende Schaltung 2 wird durch Schalter (nicht gezeigt) in den Prüfzustand versetzt. Wie in Fig. 6 gezeigt, werden die Ausgangssignale $Q_{1A}$...$Q_{8A}$ den Eingängen der vier NAND-Glieder 91...94 zugeführt. Die Ausgangssignale an den Ausgängen der Flipflops 95...98 werden den ersten vier Eingängen $Z_{1B}$...$Z_{4B}$ der zweiten eingebauten Prüfschaltung 5 (BILBO B) zugeführt. Statt dessen können die Flipflops 95...98 dazu benutzt werden, entweder einen Teil der ersten eingebauten Prüfschaltung 3 (BILBO A) oder der zweiten eingebauten Prüfschaltung 5 (BILBO B) zu bilden.

Es wird darauf hingewiesen, dass die Schaltung 2 gemäss Fig. 6 entsprechend den LSSD-Bedingungen (supra) unterteilt ist. Sie ist speziell in zwei Teile unterteilt. Ein Teil enthält die vier NAND-Glieder 91...94, der andere Teil die Flipflops 95...98.

Fig. 7 zeigt ein Ausführungsbeispiel für die zweite eingebaute Prüfschaltung 5 (BILBO B). Die Hardware-Auslegung der zweiten eingebauten Prüfschaltung 5 (BILBO B) ist die gleiche wie die Hardware-Auslegung der ersten eingebauten Prüfschaltung 3 (BILBO A) gemäss Fig. 3.

Deshalb sind Elemente, die den Elementen gemäss Fig. 3 entsprechen, mit gleichen Bezugszeichen, allerdings mit dem Zusatz 1 an deren Anfang gekennzeichnet. Die zweite eingebaute Prüfschaltung 5 (BILBO B) enthält acht Flipflops 141...148, acht UND-Glieder 151...158, acht NOR-Glieder 161...168, acht Exklusiv-ODER-Glieder 171...178 und drei zusätzliche Exklusiv-ODER-Glieder 179...181 in einer Rückkopplungsschleife. Eine ins einzelne gehende Beschreibung dieser Schaltung erscheint nach dem vorher Gesagten nicht notwendig.

Fig. 7 kann entnommen werden, dass das erste Steuersignal $B_{1B}=1$ mit $B_{1B}=1$ und das zweite Steuersignal $B_{2B}$ mit $B_{2B} = 0$ gewählt ist. Zu diesem Zwecke ist der erste Steuereingang mit einer Spannungsklemme, die das Potential $+V$ hat, verbunden, und der zweite Steuereingang ist mit Erdpotential verbunden.

Infolge der Auswahl der Steuersignale $B_{1B}$ und $B_{2B}$ ist die zweite eingebaute Prüfschaltung 5 (BILBO B) als Parallel-Eingangswort-Analysator geschaltet. Die Funktion dieser zweiten eingebauten Prüfschaltung 5 (BILBO B) besteht darin, die Testdaten, die durch vier Signale an den Klemmen $Z_{1B}$, $Z_{2B}$, $Z_{3B}$ und $Z_{4B}$, vgl. auch Fig. 6, repräsentiert werden, am Ausgang der zu prüfenden Schaltung 2 aufzufangen. Zusätzlich empfängt die zweite eingebaute Prüfschaltung 5 (BILBO B) vier Eingangssignale, die entweder den logischen Wert «1» oder den logischen Wert «0» einnehmen, an den Eingängen $Z_{5B} \ldots Z_{8B}$.

Es wird nochmals darauf hingewiesen, dass die zweite eingebaute Prüfschaltung 5 (BILBO B) identisch mit der ersten eingebauten Prüfschaltung 3 (BILBO A) gemäss Fig. 3 ist, allerdings mit einer Ausnahme, nämlich der Art und Weise, wie der Weg des ersten Steuersignals $B_{1B}$ bereitgestellt wird. Im vorliegenden Fall (Fig. 7) ist der erste Eingang ständig mit einer Stromversorgung verbunden, die eine Betriebsspannung $+V$ über einen Widerstand liefert, während gemäss Fig. 2 der erste Steuereingang mit dem Ausgang der Steuerschaltung 20 verbunden ist. Ausserdem ist zu bemerken, dass ein Standard-Schaltkreis entsprechend Fig. 4 und Fig. 5 als Flipflops 141 ... 148 verwendet werden kann.

Wie bereits zuvor anhand Fig. 2 erläutert, werden die Ausgangssignale $Q_{1B} \ldots Q_{8B}$ den Eingängen des Decoders 6 zugeführt. Die Funktion des Decoders 6 (vgl. Fig. 2), der an die zweite eingebaute Prüfschaltung 5 (BILBO B) angeschlossen ist, besteht darin, zu entscheiden, ob die durch die zweite eingebaute Prüfschaltung 5 (BILBO B) aufgefangenen Prüfdaten ein «Gut»-Signal darstellen oder nicht. Falls sich ein «Gut»-Signal darstellen, gibt der Decoder 6 ein Signal mit dem logischen Wert «1» ab. Falls die Prüfdaten kein «Gut»-Signal darstellen, gibt der Decoder 6 ein Signal mit dem logischen Wert «0» ab. Abhängig von dem Prüfmuster und ebenso abhängig von der speziellen Schaltung 2 müssen die Werte der Signale $Q_{1B} \ldots Q_{8B}$ der zweiten eingebauten Prüfschaltung 5 (BILBO B) gegebenenfalls invertiert werden, um die gewünschte Funktion des Decoders 6 zu erreichen. In Fig. 7 ist gezeigt, dass das dritte und das achte Ausgangssignal jeweils durch einen Inverter 24 bzw. 25 invertiert werden.

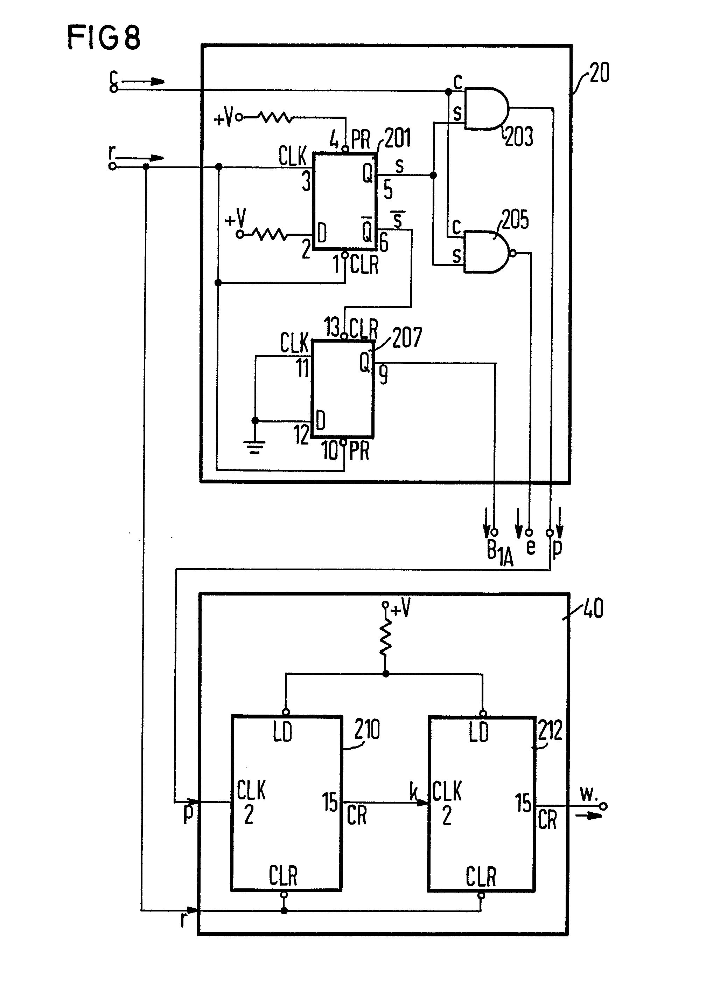

Fig. 8 zeigt jeweils ein Ausführungsbeispiel für die Steuerschaltung 20 und die Taktsteuerungsschaltung 40. Die Steuerschaltung 20 enthält ein erstes Flipflop 201 und ein UND-Glied 203, ferner ein NAND-Glied 205 und ein zweites Flipflop 207. Das Hauptrücksetzsignal r wird einem Taktsignaleingang CLK und einem Löschsignaleingang CLR des ersten Flipflop 201 zugeführt. Ein Dateneingang D und ein Rücksetzsignaleingang PR des ersten Flipflop 201 sind über Widerstände mit der Spannungsklemme $+V$ verbunden. Der Ausgang des ersten Flipflop 201 ist mit einem Eingang des UND-Gliedes 203 verbunden. Dem anderen Eingang des UND-Gliedes 203 wird das Haupttaktsignal c zugeführt. Das Ausgangssignal des ersten Flipflop 201 ist ein Zählerfreigabesignal s. Ein invertiertes Ausgabesignal $\bar{s}$ des ersten Flipflop 201 wird an den Löschsignaleingang CLR des zweiten Flipflop 207 geführt. Der Taktsignaleingang CLK und der Dateneingang D des zweiten Flipflop 207 sind auf Erdpotential gelegt, während der Rücksetzsignaleingang PR mit dem Hauptrücksetzsignal r beaufschlagt wird. Das Ausgangssignal des zweiten Flipflop 207 ist das erste Steuersignal $B_{1A}$.

Dem NOR-Glied 205 werden das Zählerfreigabesignal s und das Haupttaktsignal c zugeführt. Das Ausgangssignal des NOR-Gliedes 205 ist das Freigabesignal e.

In der Steuerschaltung 20 kann als erstes Flipflop 201 der erste Teil eines 2-fach-Flipflop-Schaltkreises 7474 und als zweites Flipflop 207 dessen zweiter Teil benutzt werden, während ein Schaltkreis 7408 als UND-Glied 203 und ein Schaltkreis 7400 als NOR-Glied 250 benutzt werden können. Diese Schaltkreisbezeichnung sind Typenbezeichnungen der Firma Texas Instruments.

Die Taktsteuerungsschaltung 40 enthält einen ersten Zähler 210 und einen zweiten Zähler 212. Beide Zähler 210, 212 sind jeweils derart ausgelegt, dass sie von 1 bis 16 (0 bis 15) zählen können. Wenn die Stellung «16» erreicht ist, springen sie in die Stellung «1» zurück. Nach 16 Impulsen wird ein Übertragssignal k an dem Übertragssignalausgang CR des ersten Zählers 210 erzeugt. In der bekannten Kombination zählen beide Zähler zusammen von 0 bis 255 und springen dann auf die Ausgangsstellung 0 zurück.

Es ist zu bemerken, dass die Ladeeingänge LD beider Zähler 210, 212 über einen gemeinsamen Widerstand mit einer Spannungsklemme, die das Potential $+V$ hat, verbunden sind. Die Löschsignaleingänge CLR werden mit dem Hauptrücksetzsignal r versorgt. Der Übertragssignalausgang CR des ersten Zählers 210 ist mit dem Taktsignaleingang CLK des zweiten Zählers 212 verbunden. Das Taktsteuerungsimpulssignal p aus der Steuerschaltung 20 wird dem Taktsignaleingang CLK des ersten Zählers 210 zugeführt. Der Übertragssignalausgang CR des zweiten Zählers 212 ist der Ausgang der Taktsteuerungsschaltung 40. Dieser Ausgang liefert das Prüfendesignal w.

Während des Betriebes zählt die Taktsteuerungsschaltung 40 von 0 bis 255, d.h. bis 255 Impulse des Haupttaktsignals c aufgetreten sind, gibt dann das Prüfendesignal w an ihrem Ausgang ab und kehrt in den anfänglichen Zustand «0» zurück.

Jeder der beiden Zähler 210 und 212 kann beispielsweise vom Typ 74171 der Firma Texas Instruments sein.

Fig. 9 zeigt verschiedene Impulsdiagramme, die die Einrichtung gemäss Fig. 2 betreffen. Auf der Grundlage dieser Impulsdiagramme wird nun die Folge der Vorgänge beim Prüfen der Schaltung 2 im einzelnen beschrieben.

Bei Beginn des Vorganges wird die gesamte Einrichtung, nämlich die zu prüfende Schaltung 2, die eingebauten Prüfschaltungen 3 und 5 (BILBO A und BILBO B) und der Decoder 6 mittels des Hauptrücksetzsignals r in eine definierte Ausgangslage zurückgesetzt. Dies kann durch Schliessen des Schalters 11 (vgl. Fig. 2) herbeigeführt werden.

Das Hauptrücksetzsignal r – ein Impuls mit einer abfallenden ersten Flanke und einer ansteigenden zweiten Flanke – ist in der ersten Abszisse in Fig. 9 gezeigt. Aufgrund dieses Impulses wird ein erstes Steuersignal $B_{1A}$ erzeugt, das in der vierten Abszisse in Fig. 9 gezeigt ist. Bei der ansteigenden Flanke des Impulses des Hauptrücksetzsignals r steigt das Zählerfreigabesignal s (vgl. zweite Abszisse des Diagramms) an, um den logischen Wert «1» einzunehmen. Wenn das Zählerfreigabesignal s ansteigt, fällt das invertierte Signal $\bar{s}$ (vgl. dritte Abszisse) ab. Wegen des Kondensators 82 wird die fallende Flanke des ersten Steuersignals $B_{1A}$ hinter die steigende Flanke des Hauptrücksetzimpulses verlegt. Der Impuls des Steuersignals $B_{1A}$ hat das Eingeben der vorbestimmten Signale an den Eingängen $Z_{1A}, Z_{2A}...Z_{8A}$, (vgl. Fig. 2) in die Flipflops 41...48 der ersten eingebauten Prüfschaltung 3 (BILBO A) zur Folge. Am Ende des Ladevorganges erreicht das Steuer- oder Ladesignal $B_{1A}$ der ersten eingebauten Prüfschaltung 3 (BILBO A) den logischen Wert «0».

Das Freigabesignal e beginnt mit der ansteigenden Flanke des Haputrücksetzsignals r.

Dieses Freigabesignal e besteht aus einer Folge von Impulsen, die mit den Nummern 1, 2, 3, 4...32...($n\cdot 16$)...256 bezeichnet sind. Das Freigabesignal e verschiebt die Inhalte der ersten und zweiten eingebauten Prüfschaltung 3 bzw. 5 (BILBO A bzw. BILBO B) wiederholt mittels eines Rückkopplungsverfahrens, bis das Ende der Prüfung erreicht ist. Wenn der Impuls mit der Nummer 16 auftritt, wird ein Impuls des Übertragssignals k (vgl. sechste Abszisse in Fig. 9) erzeugt. Dieser Impuls und die folgenden 15 Übertragsimpulse werden in dem zweiten Zähler 212 abgezählt. Das bedeutet in anderen Worten, dass mit jedem Impuls, der eine der Nummer 16, 32...($n\cdot 16$)... in dem Freigabesignal e aufweist, ein Impuls in dem Übertragssignal k erzeugt wird. Dies setzt sich fort, bis der Impuls, der die Nummer 256 in dem Freigabesignal e hat, erreicht worden ist. Gleichzeitig wird ein Impuls als Ausgangssignal der Taktsteuerungsschaltung 40, nämlich das Prüfendesignal w, erzeugt, wie aus der letzten Abszisse in Fig. 9 zu erkennen ist. Dieser Impuls wird dem NAND-Glied 32 und dem Decoder 6 zugeführt. Während der Impulszeit des Impulses in dem Prüfendesignal w wird ein Zustandssignal von dem NAND-Glied 30 zu den Zustandsanzeigern 7 und 8 übertragen. Aufgrund des Freigabesignals e wird die anfängliche Eingangsinformation an den Eingängen $Z_{1A}...Z_{8A}$ durch die Reihe von Flipflops 41...48 von 256/8 = 32 Zyklen geschoben. Während dieser 32 Zyklen empfängt die zu prüfende Schaltung 2 256 verschiedene Eingangskonfigurationen $Q_{1A}...Q_{8A}$ aus der ersten eingebauten Prüfschaltung 3 (BILBO A). Die Schaltung 2 gibt daraufhin $2^4 = 16$ verschiedene Ausgangskonfigurationen an die Eingänge $Z_{1B}...Z_{4B}$ ab.

Diese Daten werden zusammen mit der ständig vorhandenen Information an den Eingängen $Z_{5B}...Z_{8B}$ durch die zweite eingebaute Prüfschaltung 5 (BILBO B) ebenfalls 32mal aufgrund des Freigabesignals e geschoben. Deshalb erscheinen am Ausgang der zweiten eingebauten Prüfschaltung 5 (BILBO B) 256 verschiedene Ausgangskombinationen $Q_{1B}...Q_{8B}$. Lediglich die letzte Kombination entsprechend dem Impuls 256 in dem Freigabesignal e wird im Decoder 6 für die Fehlerprüfzwecke verwendet. In anderen Worten ausgedrückt, es wird die Eingangsinformation an den Eingängen $Z_{1A}...Z_{8A}$ durch die erste eingebaute Prüfschaltung 3 (BILBO A), die zu prüfende Schaltung 2 und die zweite eingebaute Prüfschaltung 5 (BILBO B) im Laufe von 255 aufeinanderfolgenden Impulsen verarbeitet, und es wird lediglich dann, wenn der letzte Impuls dieser Folge auftritt, der Ausgang des Decoders 6 und damit die Funktion oder Fehlfunktion der zu prüfenden Schaltung 2 festgestellt.

## Patentansprüche

1. Einrichtung zum Prüfen einer digitalen elektronischen Schaltung mittels in diese Schaltung eingebauter Prüfschaltungen (3, 5), wobei eine erste eingebaute Prüfschaltung (3) zum Erzeugen eines Pseudo-Zufall-Prüfmusters vorgesehen ist,
– wobei die erste eingebaute Prüfschaltung (3) an die Eingänge der zu prüfenden Schaltung (2) angeschaltet ist,
– wobei die erste eingebaute Prüfschaltung (3) Eingangssignal-Eingänge ($Z_{1A}...Z_{8A}$) und Steuersignal-Eingänge ($B_{1A}, B_{2A}$) sowie eine Anzahl in Reihe geschalteter Speicherelemente (41...48) und Mittel (61...68, 71...78) zum Anpassen der logischen Pegel von Eingangssignalen an die Eingänge dieser Speicherelemente (41...48) aufweist, welche Mittel (61...68, 71...78) einen Ausgang zumindest eines Speicherelementes (41...48) mit dem Eingang eines anderen Speicherelementes (41...48) verbinden,
– wobei eine zweite eingebaute Prüfschaltung (5) zum Analysieren eines Parallel-Eingabewortes vorgesehen ist,
– wobei die zweite eingebaute Prüfschaltung (5) an die Ausgänge der zu prüfenden Schaltung (2) angeschlossen ist und eine Anzahl in Reihe geschalteter Speicherelemente (141...148) und Mittel zum Anpassen (161...168, 171...178) der Eingangssignale für diese Speicherelemente (141...148) hat, die den Ausgang zumindest eines Speicherelementes (141...148) und den Eingang eines weiteren Speicherelementes (141...148) verbinden,
– wobei ein Decoder (6) vorgesehen ist, von welchem Eingänge ($Q_{1B}...Q_{8B}$) mit Ausgängen der zweiten eingebauten Prüfschaltung (5) zum Empfangen von Eingangssignalen einer vorbestimmten Kombination von logischen Pegeln für den Fall, dass die zu prüfende Schaltung (2) fehlerfrei ist, und einer von der vorbestimmten Kombination unterschiedlichen Kombination von logischen Pegeln für den Fall, dass die zu prüfende Schaltung (2) fehlerhaft ist, verbunden sind, und

– wobei die zweite eingebaute Prüfschaltung (5) eine Vielzahl von Eingangssignal-Eingängen ($Z_{1B}...Z_{8B}$) hat, wobei eine erste Gruppe dieser Eingangssignal-Eingänge ($Z_{1B}...Z_{8B}$) über Schalter (22) mit Ausgängen der zu prüfenden Schaltung (2) verbunden ist und eine zweite Gruppe dieser Eingänge ($Z_{1B}...Z_{8B}$) über Schalter (22) mit Eingangssignalen versorgt wird, die einen ersten logischen Wert, z. B. «1», repräsentieren, dadurch gekennzeichnet,

– dass ein Ausgang des Decoders (6) zum Ausgeben eines ersten Ausgangssignals für den Fall, dass die zu prüfende Schaltung (2) fehlerfrei, und zum Liefern eines zweiten Ausgangssignals für den Fall, dass die zu prüfende Schaltung (2) fehlerhaft ist, vorgesehen ist,

– dass zumindest ein Zustandsanzeiger (7 oder 8) vorgesehen ist, der mit dem Ausgang des Decoders (6) zum Anzeigen des Zustandes der zu prüfenden Schaltung (2) verbunden ist,

– dass Mittel (20, 40) zum Steuern der ersten eingebauten Prüfschaltung (3) und des Decoders (6) in Abhängigkeit von einem Haupttaktsignal (c) vorgesehen sind,

– dass die Mittel zum Steuern eine Steuerschaltung (20) und eine Taktsteuerungsschaltung (40), die durch einen Taktsteuerungsimpuls (p) aus der Steuerschaltung (20) gesteuert wird, umfassen,

– dass die Taktsteuerungsschaltung (40) ein Prüfendesignal (w) an den Decoder (6) liefert, nachdem eine vorbestimmte Anzahl von Taktimpulsen des Haupttaktsignals (c; c') aufgetreten ist, wobei das Prüfendesignal (w) das Ende der Prüfung der zu prüfenden Schaltung (2) anzeigt,

– dass die Steuerschaltung (20) ein Freigabesignal (e) zum Steuern der ersten eingebauten Prüfschaltung (3) und der zweiten eingebauten Prüfschaltung (5) bildet, wobei das Freigabesignal (e) aus einer Folge mit einer vorbestimmten Anzahl von Impulsen besteht,

– dass die Steuerschaltung (20) ausserdem das Prüfendesignal (w) zum Zeitpunkt des Auftretens des letzten Impulses der Folge mit einer vorbestimmten Anzahl von Impulsen bewirkt,

– dass das Prüfendesignal (w) einer Blockiereinrichtung (32) zwecks Abgabe derjenigen Information an den jeweiligen Zustandsanzeiger (7; 8) zugeführt wird, die gerade in dem Decoder (6) präsent ist,

– dass die erste eingebaute Prüfschaltung (3) eine Vielzahl von Eingangssignal-Eingängen ($Z_{1A}...Z_{8A}$) hat, die in eine erste Gruppe und eine zweite Gruppe eingeteilt sind,

– dass erste Eingangssignale, die den logischen Wert «0» repräsentieren, dieser ersten Gruppe von Eingängen, und zweite Eingangssignale, die den logischen Wert «1» repräsentieren, dieser zweiten Gruppe von Eingängen zugeführt werden,

– dass Ausgänge ($Q_{1B}...Q_{8B}$) der zweiten eingebauten Prüfschaltung (5) nichtinvertierte Ausgangssignale ausgegeben,

– dass jeder aus einer ersten Gruppe der Ausgänge ($Q_{3B}$, $Q_{8B}$) der zweiten eingebauten Prüfschaltung (5) über jeweils einen individuellen Inverter (24, 25) mit dem Decoder (6) verbunden ist, wobei diese erste Gruppe von Ausgängen ($Q_{3B}$, $Q_{8B}$) Ausgangssignale mit einem ersten logischen Pegel für den Fall abgibt, dass die zu prüfende Schaltung (2) fehlerfrei ist, und

– dass die Ausgänge der Inverter (24, 25) und eine zweite Gruppe von Ausgängen ($Q_{1B}$, $Q_{2B}$, $Q_{4B}$, $Q_{5B}$, $Q_{6B}$ und $Q_{7B}$) der zweiten eingebauten Prüfschaltung (5) mit entsprechenden Eingängen des Decoders (6) verbunden sind, wobei jeder Ausgang der zweiten Gruppe einen zweiten logischen Pegel für den Fall aufweist, dass die zu prüfende Schaltung (2) fehlerfrei ist.

2. Einrichtung nach Anspruch 1, dadurch gekennzeichnet, dass das Haupttaktsignal (c) aus der zu prüfenden Schaltung (2) gewonnen wird.

3. Einrichtung nach Anspruch 1, dadurch gekennzeichnet, dass das Haupttaktsignal (c') aus einer Haupttakt- und Rücksetzschaltung (12), die zusätzlich zu der zu prüfenden Schaltung (2) vorgesehen ist, gewonnen wird.

4. Einrichtung nach Anspruch 4, dadurch gekennzeichnet, dass die Blockiereinrichtung ein UND-Glied (32) ist.

5. Einrichtung nach Anspruch 4, dadurch gekennzeichnet, dass die Taktsteuerungsschaltung (40) zumindest einen Zähler enthält.

6. Einrichtung nach Anspruch 1, dadurch gekennzeichnet, dass die Folge von Impulsen die vorbestimmte Anzahl von 256 Impulsen enthält.

**Claims**

1. A device for testing a digital electronic circuit by means of test circuits (3, 5) which are incorporated into this circuit, where a first integrated test circuit (3) is provided to generate a pseudorandom test pattern,

– where the first integral test circuit (3) is connected to the inputs of the circuit (2) to be tested,

– where the first integral test circuit (3) has input signal inputs ($Z_{1A}....Z_{8A}$) and control signal inputs ($B_{1A}$, $B_{2A}$), a number of series connected storage elements (41...48) and means (61...68, 71...78) which serve to adapt the logic level of input signals to the inputs of the storage elements (41...48), which means (61...68, 71...78) connect an output of at least one storage element (41...48) to the input of another storage element (41...48),

– where a second integral test circuit (5) is provided to analyse a parallel input word,

– where the second integral test circuit (5) is connected to the outputs of the circuit (2) to be tested and has a number of series connected storage elements (141...148) and means (161...168, 171...178) which serve to adapt the input signals for these storage elements (141...148) and which connect the output of at least one storage element (141...148) and the input of a further storage element (141...148),

– where a decoder (6) is provided, of which inputs ($Q_{1B}...Q_{8B}$) are connected to outputs of the second integral test circuit (5) in order to receive input signals comprising of a predetermined combination of logic levels in the event that the circuit (2) to be tested is fault-free and which comprise a combination of logic levels which differs from the predetermined combination in the event that the circuit (2) to be tested is faulty, and

– where the second integral test circuit (5) has a number of input signal inputs ($Z_{1B}...Z_{8B}$), where a first group of these input signal inputs ($Z_{1B}...Z_{8B}$) is connected via switches (22) to outputs of the circuit (2) to be tested, and a second group of these inputs ($Z_{1B}...Z_{8B}$) is supplied, via switches (22), with input signals which represent a first logic value, e.g. «1», characterised in that

– an output of the decoder (6) serves to emit a first output signal in the event that the circuit (2) to be tested is fault-free and to supply a second output signal in the event that the circuit (2) to be tested is faulty,

– that at least one status indicator (7 or 8) is provided, which is connected to the output of the decoder (6) in order to indicate the status of the circuit (2) to be tested,

– that means (20, 40) are provided which serve to control the first integral test circuit (3) and the decoder (6) in dependence upon a main clock signal (c),

– that the control means comprise a control circuit (20) and a clock control circuit (40) which is controlled by a clock control pulse (p) from the control circuit (20),

– that the clock control circuit (40) supplies the decoders (6) with an end-of-test signal (w) when a predetermined number of clock pulses of the main clock signal (c; c') have occurred, where the end-of-test signal (w) indicates the end of the testing of the circuit (2) to be tested,

– that the control circuit (20) forms a release signal (e) which controls the first integral test circuit (3) and the second integral test circuit (5), where the release signal (e) comprises a sequence of a predetermined number of pulses,

– that the control circuit (20) also produces the end-of-test signal (w) at the time of the occurrence of the last pulse of the sequence of a predetermined number of pulses,

– that the end-of-test signal (w) is fed to a blocking device (32) in order to emit to the respective status indicator (7; 8) that item of information which is currently present in the decoder (6),

– that the first integral test circuit (3) has a plurality of input signal inputs ($Z_{1A}...Z_{8A}$) which are sub-divided into a first group and a second group,

– that first input signals, which represent the logic value «0», are fed to this first group of inputs and second input signals, which represent the logic value «1», are fed to this second group of inputs,

– that outputs ($Q_{1B}...Q_{8B}$) of the second integral test circuit (5) emit non-inverted output signals,

– that each output of a first group of outputs ($Q_{3B}$, $Q_{8B}$) of the second integral test circuit (5) is connected via an individual inverter (24, 25) to the decoder (6), where this first group of outputs ($Q_{3B}$, $Q_{8B}$) emits output signals having a first logic level in the event that the circuit (2) to be tested is fault-free and

– that the outputs of the inverters (24, 25) and a second group of outputs ($Q_{1B}$, $Q_{2B}$, $Q_{4B}$, $Q_{5B}$, $Q_{6B}$ and $Q_{7B}$) of the second integral test circuit (5) are connected to corresponding inputs of the decoder (6), where each output of the second group has a second logic level in the event that the test circuit (2) to be tested is fault-free.

2. A device as claimed in claim 1, characterised in that the main clock signal (c) is obtained from the circuit (2) to be tested.

3. A device as claimed in claim 1, characterised in that the main clock signal (c') is obtained from a main clock-and reset circuit (12) which is provided in addition to the circuit (2) to be tested.

4. A device as claimed in claim 4, characterised in that the blocking device is an AND-gate (32).

5. A device as claimed in claim 4, characterised in that the clock control circuit (40) includes at least one counter.

6. A device as claimed in claim 1, characterised in that the sequence of pulses includes the predetermined number of 256 pulses.

**Revendications**

1. Dispositif pour tester un circuit électronique numérique à l'aide de circuits de contrôle (3, 5) incorporés dans ce circuit, et dans lequel il est prévu un premier circuit de contrôle incorporé (3) servant à produire un profil d'essai pseudo-aléatoire et dans lequel

– le premier circuit de contrôle incorporé (3) est raccordé aux entrées du circuit à tester (2),

– le premier circuit de contrôle incorporé (3) comporte des entrées ($Z_{1A}...Z_{8A}$) pour des signaux d'entrée et des entrées ($B_{1A}$, $B_{2A}$) pour des signaux de commande ainsi qu'un nombre d'éléments de mémoire (41...48) branchés en série et des moyens (61...68; 71...78) pour l'adaptation des niveaux logiques de signaux d'entrée aux entrées de ces éléments de mémoire (41...48), lesquels moyens (61...68, 71...78) relient une sortie d'au moins un élément de mémoire (41...48) à l'entrée d'un autre élément de mémoire (41...48),

– il est prévu un second circuit de contrôle incorporé (5) pour réaliser l'analyse d'un mot d'entrée en parallèle,

– le second circuit de contrôle incorporé (5) est raccordé aux sorties du circuit à tester (2) et un nombre d'éléments de mémoire (141...148) branchés en série et comporte des moyens (161...168, 171...178) pour adapter les signaux d'entrée pour ces éléments de mémoire (141...148), qui relient la sortie d'au moins un élément de mémoire (141...148) et l'entrée d'un autre élément de mémoire (141...148),

– il est prévu un décodeur (6) dont les entrées ($Q_{1B}...Q_{8B}$) sont reliées à des sorties du second circuit de contrôle incorporé (5) pour la réception de signaux d'entrée d'une combinaison prédéterminée de niveaux logiques dans le cas où le circuit à tester (2) ne présente aucune erreur, et d'une combinaison de niveaux logiques, qui diffère de la combinaison prédéterminée, dans le cas où le circuit à tester (2) est défectueux, et

– le second circuit de contrôle incorporé (5) comporte une multiplicité d'entrées ($Z_{1B} ... Z_{8B}$) de signaux d'entrée, auquel cas un premier groupe de ces entrées ($Z_{1B} ... Z_{8B}$) de signaux d'entrée est relié par l'intermédiaire de commutateurs (22) à des sorties du circuit à tester (2) et un second groupe de ces entrées ($Z_{1B} ... Z_{8B}$) est alimenté par l'intermédiaire de commutateurs (22) par des signaux d'entrée qui représentent une première valeur logique, par exemple «1», caractérisé par le fait:

– qu'il est prévu une sortie du décodeur (6) servant à délivrer un premier signal de sortie dans le cas où le circuit devant être testé (2) est exempt de défaut, et pour délivrer un second signal de sortie dans le cas où le circuit à tester (2) est défectueux,

– qu'il est prévu au moins un indicateur d'état (7 ou 8), qui est relié à la sortie du décodeur (6) pour l'affichage de l'état du circuit à tester (2),

– qu'il est prévu des moyens (20, 40) servant à commander le premier circuit de contrôle incorporé (3) et le décodeur (6) en fonction d'un signal de cadence principal (6),

– que les moyens de commande comprennent un circuit de commande (20) et un circuit de commande de cadence (40), qui est commandé par une impulsion de commande de cadence (p) délivrée par le circuit de commande (20),

– que le circuit de commande de cadence (40) délivre un signal de fin de contrôle (w) au décodeur (6) une fois qu'un nombre prédéterminé d'impulsions de cadence du signal de cadence principal (c; c') est apparu, auquel cas le signal de fin de contrôle (w) indique la fin du contrôle du circuit à tester (2),

– que le circuit de commande (20) forme un signal de libération (e) servant à commander le premier circuit de contrôle incorporé (3) et le second circuit de contrôle incorporé (5), auquel cas le signal de libération (e) est constitué par une suite comportant un nombre prédéterminé d'impulsions,

– que le circuit de commande (20) produit en outre le signal de fin de contrôle (w) à l'instant de l'apparition de la dernière impulsion de la suite comportant un nombre prédéterminé d'impulsions,

– que le signal de fin de contrôle (w) est envoyé à un dispositif de blocage (32) en vue de provoquer l'envoi de l'information, qui est précisément présente dans le décodeur (6), à l'indicateur respectif d'état (7; 8),

– que le premier circuit de contrôle incorporé (3) possède une multiplicité d'entrées ($Z_{1A} ... Z_{8A}$) de signaux d'entrée, qui sont réparties en un premier groupe et en un second groupe,

– que des premiers signaux d'entrée, qui représentent la valeur logique «0», sont envoyés à ce premier groupe d'entrées et que des seconds signaux qui représentent la valeur logique «1» sont envoyés à ce second groupe d'entrées,

– que des sorties ($Q_{1B} ... Q_{8B}$) du second circuit de contrôle incorporé (5) délivrent des signaux de sortie non inversés,

– que chaque sortie faisant partie d'un premier groupe de sorties ($Q_{3B}$, $Q_{8B}$) du second circuit de contrôle incorporé (5) est reliée par l'intermédiaire d'un inverseur individuel respectif (24, 25) au décodeur (6), auquel cas ce premier groupe de sorties ($Q_{3B}$, $Q_{8B}$) délivre des signaux de sortie possédant un premier niveau logique pour le cas où le circuit à tester (2) est exempt de défaut, et

– que les sorties des inverseurs (24, 25) et un second groupe de sorties ($Q_{1B}$, $Q_{2B}$, $Q_{4B}$, $Q_{5B}$, $Q_{6B}$ et $Q_{7B}$) du second circuit de contrôle incorporé (5) sont reliées à des entrées correspondantes du décodeur (6), auquel cas chaque sortie du second groupe comporte un second niveau logique dans le cas où le circuit à tester (2) est exempt de défauts.

2. Dispositif suivant la revendication 1, caractérisé par le fait que le signal de cadence principal (c) est obtenu à partir du circuit à tester (2).

3. Dispositif suivant la revendication 1, caractérisé par le fait que le signal de cadence principal (c') est obtenu à partir d'un circuit (12) de cadence principal et de remise à l'état initial, qui est prévu en supplément du circuit à tester (2).

4. Dispositif suivant la revendication 4, caractérisé par le fait que le dispositif de blocage est un circuit ET (32).

5. Dispositif suivant la revendication 4, caractérisé par le fait que le circuit de commande de cadence (40) contient au moins un compteur.

6. Dispositif suivant la revendication 1, caractérisé par le fait que la suite d'impulsions contient le nombre prédéterminé de 256 impulsions.

FIG 1

BILBO A — 3

— 2

BILBO B — 5

— 6

— 4

7 — ⎡ ⎤ — 8

FIG 9

r

s

$\overline{s}$

$B_{1A}$

e    1    2    3    4    16    32    n·16    256

k

w

# FIG 2

FIG 3

FIG 4

FIG 5

| Eingangssignale | | | | Ausgangssignal |
|---|---|---|---|---|
| CLEAR | ENABLE | | D | Q |
| | $\overline{G1}$ | $\overline{G2}$ | | |
| H | L | L | L | L |
| H | L | L | H | H |
| H | X | H | X | $Q_0$ |
| H | H | X | X | $Q_0$ |
| L | X | X | X | L |

FIG 6

FIG 7

FIG 8

0 037 965